# EUROPEAN PATENT APPLICATION

(11) **EP 3 742 608 A1**
(43) Date of publication of application: **25.11.2020**
(21) Application number: 20175767.1
(22) Date of filing: 20.05.2020
(51) Int. Cl.: H03F 3/19, H03F 3/24, H03F 3/45, H03F 3/68, H03G 1/00

(54) **PROGRAMMABLE GAIN AMPLIFIER**

(30) Priority: 21.05.2019 US 201916418268
(71) Applicant: Infineon Technologies AG, 85579 Neubiberg (DE)
(72) Inventor: RUBINO, Carlo, 9586 Fürnitz (AT)
(74) Representative: Hersina, Günter

(57) **Abstract**

A programmable gain amplifier (400) includes a first gain stage having a first bias current path and a first intermediate node (402), a second gain stage having a second bias current path and a second intermediate node (404), a third gain stage having a third bias current path and a third intermediate node (406), a fourth gain stage having a fourth bias current path and fourth intermediate node (408), a first resistor (RE1) coupled between the first intermediate node (402) and the second intermediate node (404), and a second resistor (RE2) coupled between the third intermediate node (406) and the fourth intermediate node (408).

## Description

The present invention relates generally to a programmable gain amplifier
Millimeter Wave ("mmWave") RF transceivers for beamforming applications are gaining more popularity due to the increasing interest in the 5G communication standard. Beamforming systems deploy a phased array of antennas to generate a beam with high directivity in order to selectively transmit data in a certain direction. This is made possible by feeding each antenna with a signal in a specific phase and amplitude in relation with each other. The beamforming system thus typically includes a phase shifter and a programmable gain amplifier. To feed each antenna with the correct phase, the programmable gain amplifier should ideally have low phase error over the complete range of gain variation to maintain the correct phase. Usually this is not the case and the gain of the amplifier varies as well as the phase, thus complicating the control of the beamforming system.

Prior solutions include the use of a phase-gain map, where for each gain level the phase variation is known, and then compensated in the phase-shifter. In this way the dynamic settings of phase and amplitude for the beam steering are co-dependent, but performance is recovered by increasing the complexity level of the control. This prior art solution requires information on the gain-phase relationship for each state of each programmable gain amplifier, including channel-to-channel mismatch and chip-to-chip mismatch. Due to the extended number of channels involved in a typical phased array application, it is difficult to guarantee by design the matching behavior of all the amplifiers staying within acceptable performance limits. Therefore, prior art solutions can include calibrating the complete array for these effects as well. This calibration procedure is time consuming and requires an on-chip or off-chip measurement solution, which is not always available.

According to an embodiment, a programmable gain amplifier comprises a differential input comprising a first input node and a second input node; a differential output comprising a first output node and a second output node; a first control node and a second control node; a first cascode leg having an input coupled to the first input node, an output coupled to the first output node, a control node coupled to the first control node, and an intermediate node; a second cascode leg having an input coupled to the first input node, an output coupled to the second output node, a control node coupled to the second control node, and an intermediate node; a third cascode leg having an input coupled to the second input node, an output coupled to the first output node, a control node coupled to the second control node, and an intermediate node; a fourth cascode leg having an input coupled to the second input node, an output coupled to the second output node, a control node coupled to the first control node, and an intermediate node; a current source coupled to the first, second, third, and fourth cascode legs; a first resistor coupled between the intermediate node of the first cascode leg and the intermediate node of the second cascode leg; and a second resistor coupled between the intermediate node of the third cascode leg and the intermediate node of the fourth cascode leg.

According to another embodiment, an amplification method comprises providing a first gain stage having a first bias current path and a first intermediate node; providing a second gain stage having a second bias current path and a second intermediate node; providing a third gain stage having a third bias current path and a third intermediate node; providing a fourth gain stage having a fourth bias current path and fourth intermediate node; isolating the first intermediate node and the second intermediate node with a first resistor; and isolating the third intermediate node and the fourth intermediate node with a second resistor.

According to another embodiment, an integrated circuit comprises a plurality of signal paths each comprising a transceiver, a phase adjustment circuit, and an amplitude adjustment circuit; and a summing circuit coupled to the plurality of signal paths, wherein the transceiver comprises at least one programmable gain amplifier comprising a plurality of gain stages each having a separate bias current path, wherein first and second gain stages of the plurality of gain stages are coupled together with a first resistor, and wherein third and fourth gain stages of the plurality of gain stages are coupled together with a second resistor.

For a more complete understanding of the present invention, and the advantages thereof, reference is now made to the following descriptions taken in conjunction with the accompanying drawings, in which:
- Figure 1: is a block diagram of an exemplary 5G Phased Array Antenna implementation;
- Figure 2: is a schematic diagram of an exemplary bipolar differential programmable gain amplifier implementation;
- Figure 3: illustrates the gain and phase simulation results of the exemplary bipolar differential PGA implementation shown in Figure 2;
- Figure 4: is a schematic diagram of a bipolar differential programmable gain amplifier implementation according to an embodiment;
- Figure 5: illustrates the gain and phase simulation results of the bipolar differential PGA implementation shown in Figure 4;
- Figure 6: illustrates a comparison of the phase variation between the exemplary programmable gain amplifier of Figure 2 and the PGA embodiment of Figure 4;
- Figures 7A and 7B: are schematic diagrams of alternative bipolar and MOS programmable gain amplifier embodiments;
- Figure 8: is a schematic diagram of a Metal Oxide Semiconductor ("MOS") differential programmable gain amplifier implementation according to an embodiment; and
- Figure 9: is an admittance graph comparing the admittance across coupled emitters in the exemplary amplifier of Figure 2 and the admittance across isolated emitters in the embodiment amplifier of Figure 4.

According to embodiments described herein, a programmable gain amplifier circuit having a low phase error is provided. The programmable gain amplifier circuit includes, among other things, a differential input, a differential output, and first and second control nodes for changing the operation of the programmable gain amplifier. The programmable amplifier has a non-inverting gain mode, an inverting gain mode, and an attenuating mode. The phase is substantially constant in the non-inverting gain mode and in the inverting gain mode. The programmable gain mode can be provided as a standalone integrated circuit using various integrated circuit technologies, or as part of a larger integrated circuit including other components that would be suitable for use in a transceiver product or other component in a beamforming application.

These embodiments provide an amplifier component having a low phase error that need not be specifically measured, tracked, and compensated. For example, in an embodiment beamforming application, all of the phase adjustment in the signal paths provided to the antennas can be optionally provided by the phase shifter only for the purpose of directing the direction of the beam and not for compensating any phase errors in the beamforming system.

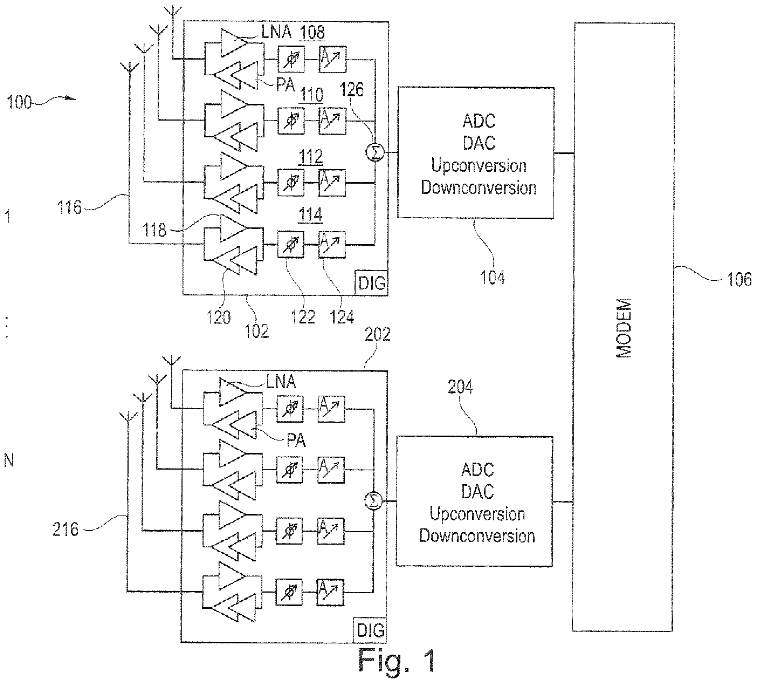

Figure 1 is a block diagram of an exemplary 5G Phased Array Antenna implementation including a plurality of transceivers 102 through 202 coupled to a plurality of conversion blocks 104 through 204 coupled to a modem 106. "N" transceivers are shown in Figure 1 and the number "N" can vary for a particular application. Each transceiver includes a plurality of signal paths 108, 110, 112, and 114 coupled between a plurality of antennas 116 and a converter 104. Transceiver 102 includes a plurality of receive amplifiers 118 and a plurality of transmit amplifiers 120 coupled to the respective antenna 116. At least one of the receive amplifiers 118 and transmit amplifiers 120 are low phase error amplifiers of the type described herein. In addition, a phase-shifter 122 and an amplitude adjustment block 124 are coupled to the output of the receive amplifiers 118 and to the input of transmit amplifiers 120. The amplitude adjustment blocks are coupled together through summing circuit 126. The output of the summing circuit 126 forms the analog input/output of the transceiver 102. A conversion block 104 includes circuitry such as an Analog to Digital Converter ("ADC") for converting the analog output signals of the transceiver 102 into digital signals for interacting with the modem 106, and circuitry such as a Digital to Analog Converter ("DAC") for converting the digital signals of the modem 106 into analog signals that can be transmitted through transceiver 102 and to the plurality of antennas 116.

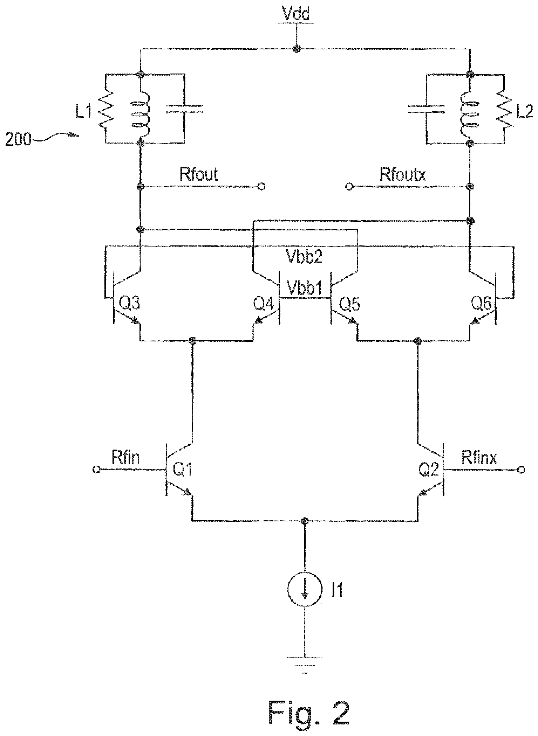

Figure 2 is a schematic diagram of an exemplary bipolar differential programmable gain amplitude circuit implementation 200, which, in an embodiment, can comprise amplitude adjustment block 124 shown in Figure 1. Circuit 200 includes a differential input pair of transistors Q1 and Q2 for receiving a differential input voltage Rfin and Rfinx. The emitters of transistors Q1 and Q2 are coupled together and to constant current source I1. A first cascode amplifier including transistors Q3 and Q4 is coupled to the collector of transistor Q1 and a second cascode amplifier including transistors Q5 and Q6 is coupled to the collector of transistors Q5 and Q6. The collectors of transistors Q3 and Q5 are coupled together and to a first load terminal Rfout. The collectors of transistors Q4 and Q6 are coupled together and to a second load terminal Rfoutx. Load terminal Rfout is coupled to a first load, such as complex load L1. Loads L1 and L2 can in turn be coupled to a power supply voltage such as a positive power supply voltage Vdd. Load terminal Rfoutx is coupled to a second load, such as complex load L2. Load terminals Rfout and Rfoutx comprise a differential output voltage.

Programmable gain for circuit 200 is provided by control signal Vbb1 coupled to the bases of transistors Q4 and Q5, and control signal Vbb2 coupled to the bases of transistors Q3 and Q6. In a first mode of operation control voltage Vbb2 is greater than control voltage Vbb1, and thus amplifier 200 provides an inverting gain between the differential input and the differential output. In a second mode of operation control voltage Vbb2 is less than control voltage Vbb1, and thus amplifier 200 provides a non-inverting gain between the differential input and the differential output. In a third mode of operation, the control voltages Vbb1 and Vbb2 are made equal and thus amplifier 200 provides attenuation between the differential input and the differential output.

Phase variation can occur in circuit 200 during the inverting and non-inverting modes of operation. Current steering programmable gain amplifiers such as those shown in circuit 200 use the current control circuit including control voltages Vbb1 and Vbb2 described above to change the biasing of active devices Q3, Q4, Q5, and Q6. Junction capacitances of these active devices are nonlinear and bias dependent, and the bias variation in circuit 200 produces a modulation of these capacitances, that act as varactors. The nodes Vbb1 and Vbb2 are polarized with two complementary control voltages. When the control voltages are equal, the signals at the collector of the two pairs of transistors cancel each other and there is maximal attenuation. In other gain modes of operation, when one control voltage is at maximum and the other control voltage is at minimum, two transistors are off and the other two are on, having the maximal gain with phase of 0° or 180°, depending on which transistor pair is on. In the maximum gain operational modes, the emitters of one on-transistor and one off-transistor are connected together, so the on-transistor imposes a voltage on the off-transistor emitter and collector and relative junction capacitances, summing up to an incomplete compensation during the current steering.

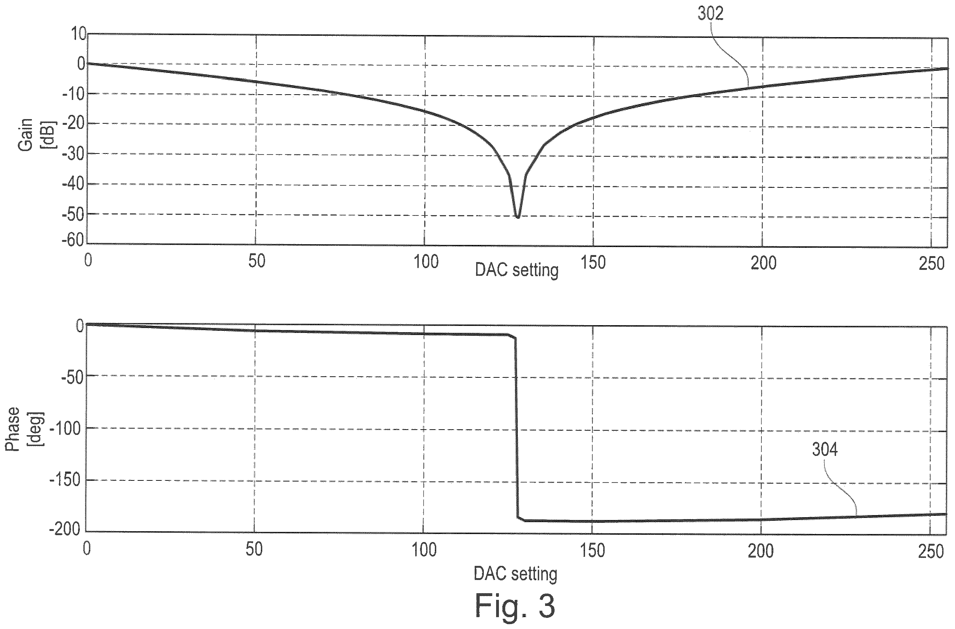

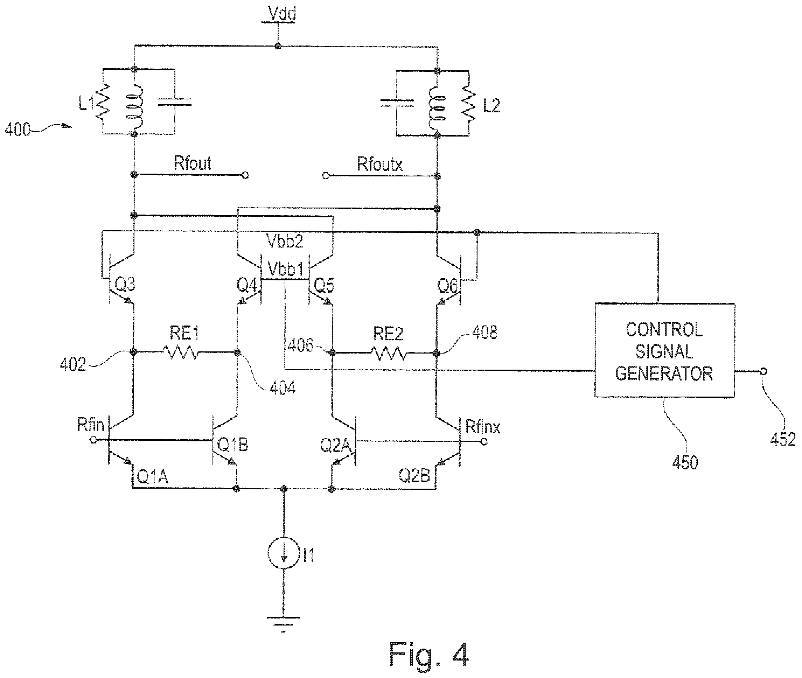

Figure 3 illustrates the gain and phase simulation results of the exemplary bipolar differential programmable gain amplifier circuit implementation 200 shown in Figure 2. Figure 3 plots gain 302 versus a DAC (Digital to Analog Converter) setting for generating control voltages Vbb1 and Vbb2. A "DAC setting" can be an arbitrary number of digital input number settings from, for example, zero to 256 that represent and are converted into an analog output voltage or current from, for example, zero to two volts, or negative two volts to positive two volts, or in the case of a current zero to two milliamperes, or negative two milliamperes to positive two milliamperes. A DAC can be used, for example, in the control signal generator 450 shown and described with respect to Figure 4 below. Figure 3 also plots phase 304 versus the DAC setting for generating control voltages Vbb1 and Vbb2. In an embodiment, Vbb1 can range between zero and two volts, and Vbb2 can also range between zero and two volts. Thus, the differential voltage between Vbb1 and Vbb2 can be configured to range between negative two volts and positive two volts. It will be understood by those skilled in the art that other voltage ranges can be used for Vbb1 and Vbb2, which also results in different ranges for the differential voltage between Vbb1 and Vbb2. The simulation results of the exemplary circuit implementation 200 are shown in Figure 3, including a phase deviation up to 8° at a 28 GHz operating frequency. The phase deviation is evident both in the non-inverting gain mode of operation (left portion of Figure 3) and the inverting gain mode of operation (right portion of Figure 3).

Circuit 400 of Figure 4 provides an implementation in which the emitters of transistors Q3 and Q4 are decoupled through resistor RE1, and wherein the emitters of transistors Q5 and Q6 are decoupled through resistor RE2, in order to mitigate the varactor effect previously discussed. In Figure 4, the emitter areas of transistors Q3, Q4, Q5, and Q6 are made equal, in an embodiment. The resistors RE1 and RE2 added between the differential pair (Q1A/Q1B and Q2A/Q2B) and the cascode amplifiers (Q3/Q4 and Q5/Q6) are used to isolate the emitters of the cascode amplifiers, without overly impacting the functionality of the circuitry (such as the value or linearity of the gain provided by the amplifier). The value for each of resistors RE1 and RE2 is in a range of 5 to 25 Ohms as previously discussed, and can be about 10 Ohm, in an embodiment. An example range is 5 to 25 ohms in an embodiment, and the selection of the resistors RE1 and RE2 may involve a trade-off between desired gain and the amount of isolation provided between the transistor emitter capacitances. A complete isolation using an open circuit for resistors RE1 and RE2 will lead to zero gain, and a short circuit for resistors RE1 and RE2 will result in the circuit 200 shown in Figure 2. The amplifier circuit 400 shown in Figure 4 using RE1 and RE2 values of 10 Ohms results in a phase deviation less than 0.5°.

Figure 4 is a schematic diagram of a bipolar differential programmable gain amplifier circuit implementation 400 according to an embodiment. Programmable gain amplifier 400 comprises a differential input comprising a first input node Rfin and a second input node Rfinx, a differential output comprising a first output node Rfout and a second output node Rfoutx, a first control node Vbb2 and a second control node Vbb1. The control voltages can be provided by the control signal generator 450, which is described below in further detail. A first cascode leg Q3, Q1A includes an input coupled to the first input node, an output coupled to the first output node, a control node coupled to the first control node, and an intermediate node 402. A second cascode leg Q4, Q1B includes an input coupled to the first input node, an output coupled to the second output node, a control node coupled to the second control node, and an intermediate node 404. A third cascode leg Q5, Q2A includes an input coupled to the second input node, an output coupled to the first output node, a control node coupled to the second control node, and an intermediate node 406. A fourth cascode leg Q6, Q2B includes an input coupled to the second input node, an output coupled to the second output node, a control node coupled to the first control node, and an intermediate node. A current source I1 is coupled to the first, second, third, and fourth cascode legs and to ground. A first resistor RE1 is coupled between the intermediate node 402 of the first cascode leg and the intermediate node 404 of the second cascode leg. A second resistor RE2 is coupled between the intermediate node 406 of the third cascode leg and the intermediate node 408 of the fourth cascode leg. Thus, the first, second, third, and fourth cascode legs each comprise a first transistor coupled to a second transistor in a cascode configuration.

The control voltages Vbb1 and Vbb2 can be provided by a control signal generator circuit 450 that provides a differential voltage or two independent input voltages in response to one or more gain control signals 452. In an embodiment, control signal generator 450 can be an analog circuit for receiving an analog signal 452 from, for example, a digital to analog converter ("DAC"). Alternatively, control signal generator 450 can be a mixed analog and digital circuit for receiving a digital signal 452 from a processor.

A voltage at the first control node Vbb2 is greater than a voltage at the second control node Vbb1 in a first mode of operation (inverting gain), the voltage at the first control node Vbb2 is less than a voltage at the second control node Vbb1 in a second mode of operation (non-inverting gain), and the voltage at the first control node is equal to the voltage at the second control node in a third mode of operation (attenuation).

As was shown in the amplifier circuit 200 of Figure 2, programmable gain amplifier 400 further comprises a first load L1 coupled to the first output node and a second load L2 coupled to the second output node. The first and second loads L1 and L2 can comprise complex loads, including a resistor, an inductor, and a capacitor, for example.

The value of the first and second resistors RE1 and RE2 can include a range of resistances between about 5 and 25 ohms, for example about 10 ohms.

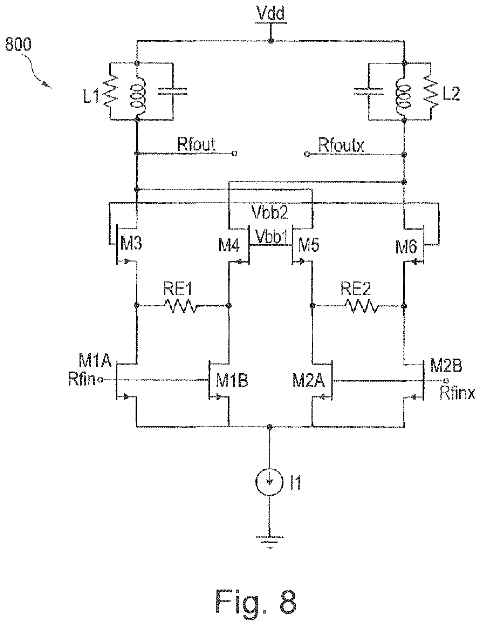

Programmable gain amplifier 400 is shown to comprise a bipolar programmable gain amplifier including bipolar transistors Q1A, Q1B, Q2A, Q2B, Q3, Q4, Q5, and Q6. However, programmable gain amplifier 400 can also comprise a Metal Oxide Semiconductor (MOS) gain amplifier including MOS transistors as is explained in further detail below with reference to Figure 8.

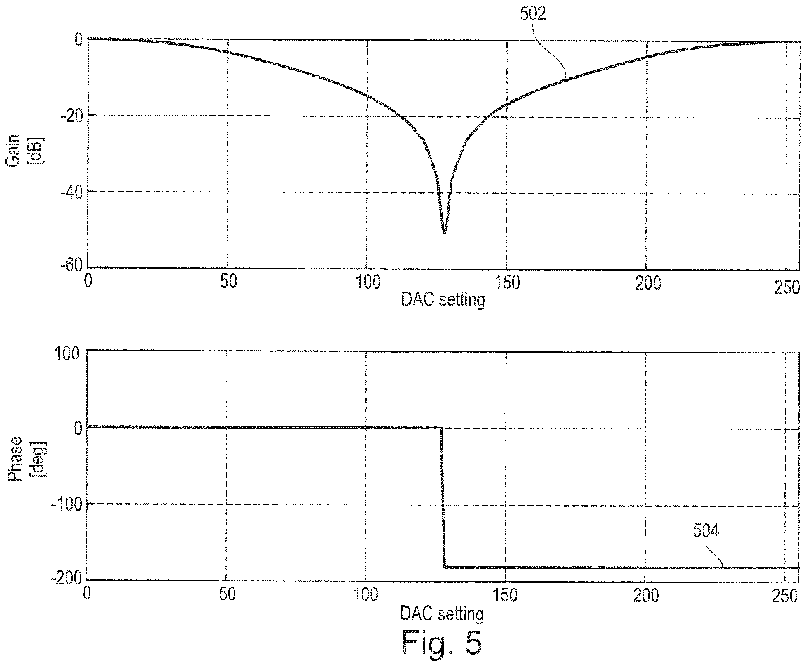

Figure 5 illustrates the gain and phase simulation results of the bipolar differential programmable gain amplifier circuit implementation 400 shown in Figure 4. Figure 5 plots gain 502 versus a DAC setting for generating control voltages Vbb1 and Vbb2. Figure 5 also plots phase 504 versus the DAC setting for generating control voltages Vbb1 and Vbb2. The simulation results of the embodiment circuit implementation 400 are shown in Figure 5, including a phase deviation less than 0.5° at a 28 GHz operating frequency. The lack of phase deviation is evident both in the non-inverting gain mode of operation (left portion of Figure 5) and the inverting gain mode of operation (right portion of Figure 5).

In summary, the use of small value emitter resistors RE1 and RE2 between the two transistor emitters (Q3/Q4 and Q5/Q6) to decouple the DC voltages and bias currents results in an improved functioning of the circuitry (particularly phase performance) without sacrificing other performance measures (such as overall gain).

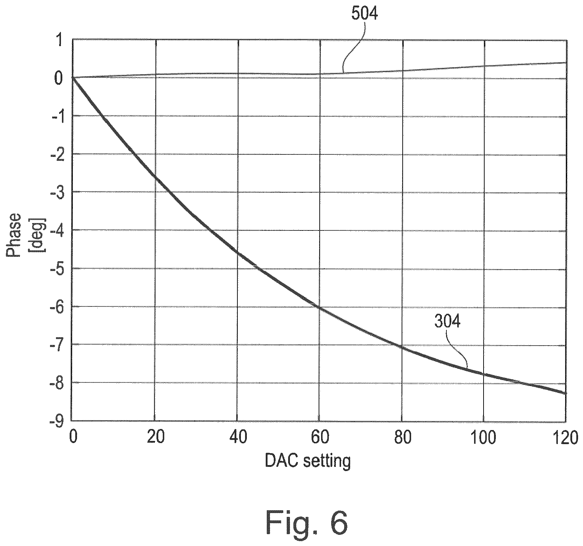

Figure 6 illustrates a comparison of the phase variation between the exemplary programmable gain amplifier of Figure 2 (phase 304) and the programmable gain amplifier embodiment of Figure 4 (phase 504). Phase 304 shows a noticeable phase variation between zero degrees and about eight degrees between DAC settings zero and 120 used to change the control voltages as previously described. However, phase 504 shows a much smaller phase variation between zero degrees and about one-half of a degree between DAC settings zero and 120.

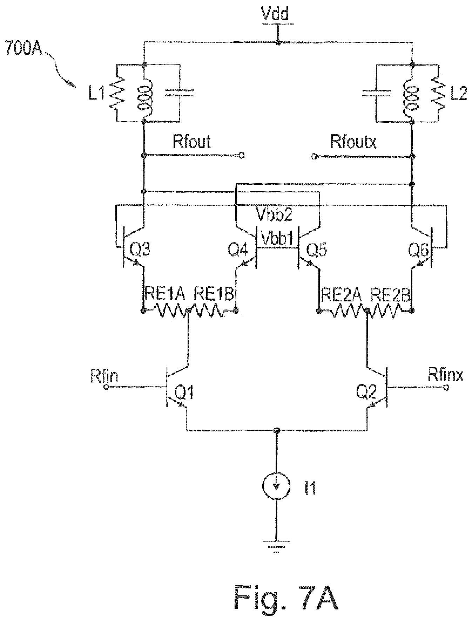

Figure 7A is a schematic diagram of an alternative bipolar programmable gain amplifier embodiment 700A similar to that of amplifier 200 shown in Figure 2. Amplifier 700A is substantially the same as amplifier 200, except that the emitters of transistors Q3 and Q4 are isolated using resistors RE1A and RE1B. The collector of transistor Q1 is coupled to the junction between resistors RE1A and RE1B. Additionally, the emitters of transistors Q5 and Q6 are isolated using resistors RE2A and RE2B. The collector of transistor Q2 is coupled to the junction between resistors RE2A and RE2B. The value of the sum of resistors RE1A and RE1B can be similar to that previously described with respect to resistor RE1. Similarly, the value of the sum of resistors RE2A and RE2B can be similar to that previously described with respect to resistor RE2. While amplifier 700A may exhibit an improvement in phase performance compared to that of amplifier 200, the gain and linearity of amplifier 700A may exhibit anomalies due to the voltage drops across the emitter resistors that vary with the differential input voltage and the corresponding current flowing through transistors Q1 and Q2.

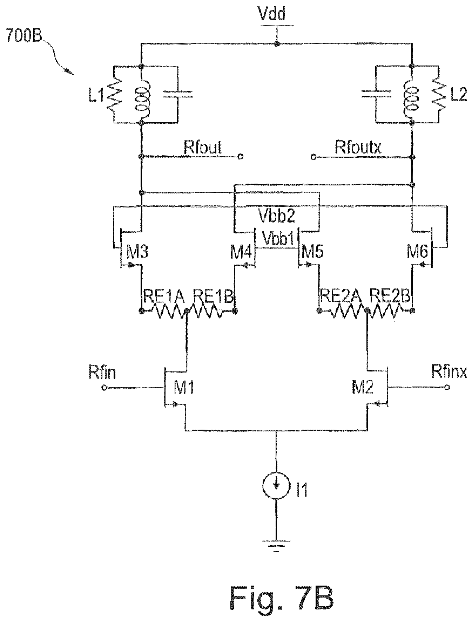

Figure 7B is a schematic diagram of a Metal Oxide Semiconductor (MOS) differential programmable gain amplifier circuit implementation 700B according to an embodiment. Amplifier 700B is substantially the same as previously described amplifier 700A shown in Figure 7A, except that bipolar transistors Q1, Q2, Q3, Q4, Q5, and Q6 have been replaced with MOS transistors M1, M2, M3, M4, M5, and M6. The performance and method of operation of amplifier 700B is substantially the same as previously described with respect to amplifier 700A shown in Figure 7A. Circuit 700B can also include the control signal generator 450 shown in Figure 4.

Figure 8 is a schematic diagram of a Metal Oxide Semiconductor (MOS) differential programmable gain amplifier circuit implementation 800 according to an embodiment. Amplifier 800 is substantially the same as previously described amplifier 400 shown in Figure 4, except that bipolar transistors Q1A, Q1B, Q2A, Q2B, Q3, Q4, Q5, and Q6 have been replaced with MOS transistors M1A, M1B, M2A, M2B, M3, M4, M5, and M6. The performance and method of operation of amplifier 800 is substantially the same as previously described with respect to amplifier 400 shown in Figure 4. Circuit 800 can also include the control signal generator 450 shown in Figure 4.

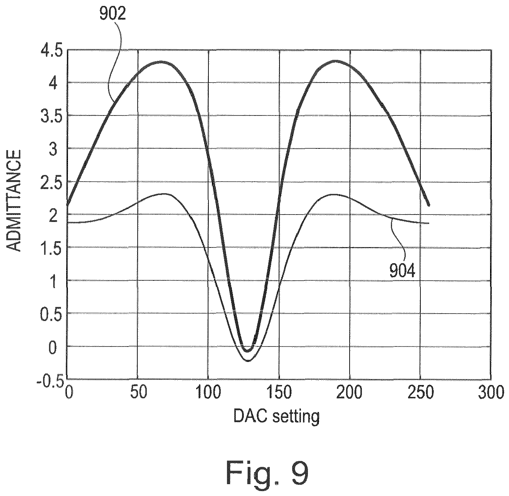

The improvement in performance between the exemplary amplifier 200 shown in Figure 2, and the embodiment amplifier 400 can be further understood by analyzing the admittance graph shown in Figure 9. The admittance units are arbitrary and only represent the relative admittances between amplifier 200 and amplifier 400 taken at the same nodes in each amplifier. The admittance measured at the coupled emitters of, for example, transistors Q3 and Q4 of exemplary amplifier 200 is shown as trace 902, which varies widely throughout the DAC setting (representative of the full range of the differential voltage between voltages Vbb1 and Vbb2). The admittance measured at the isolated emitters of, for example, transistors Q3 and Q4 of embodiment amplifier 400 is shown as trace 904, which varies substantially less throughout the DAC setting (representative of the full range of the differential voltage between voltages Vbb1 and Vbb2). The relative stability of the measured admittance of embodiment amplifier 400 due to isolation resistor RE1 results in the low phase error demonstrated by embodiment amplifier 400. The graph of Figure 9 can also pertain to the emitters of transistors Q5 and Q6, which are isolated with resistor RE2.

According to an embodiment, a programmable gain amplifier comprises a differential input comprising a first input node and a second input node; a differential output comprising a first output node and a second output node; a first control node and a second control node; a first cascode leg having an input coupled to the first input node, an output coupled to the first output node, a control node coupled to the first control node, and an intermediate node; a second cascode leg having an input coupled to the first input node, an output coupled to the second output node, a control node coupled to the second control node, and an intermediate node; a third cascode leg having an input coupled to the second input node, an output coupled to the first output node, a control node coupled to the second control node, and an intermediate node; a fourth cascode leg having an input coupled to the second input node, an output coupled to the second output node, a control node coupled to the first control node, and an intermediate node; a current source coupled to the first, second, third, and fourth cascode legs; a first resistor coupled between the intermediate node of the first cascode leg and the intermediate node of the second cascode leg; and a second resistor coupled between the intermediate node of the third cascode leg and the intermediate node of the fourth cascode leg.

According to another embodiment, a programmable gain amplifier comprises a first gain stage having a first bias current path and a first intermediate node; a second gain stage having a second bias current path and a second intermediate node; a third gain stage having a third bias current path and a third intermediate node; a fourth gain stage having a fourth bias current path and fourth intermediate node; a first resistor coupled between the first intermediate node and the second intermediate node; and a second resistor coupled between the third intermediate node and the fourth intermediate node.

According to another embodiment, an integrated circuit comprises a plurality of signal paths each comprising a transceiver, a phase adjustment circuit, and an amplitude adjustment circuit; and a summing circuit coupled to the plurality of signal paths, wherein the transceiver comprises at least one programmable gain amplifier comprising a plurality of gain stages each having a separate bias current path, wherein first and second gain stages of the plurality of gain stages are coupled together with a first resistor, and wherein third and fourth gain stages of the plurality of gain stages are coupled together with a second resistor.

According to another embodiment, an amplification method comprises providing a first gain stage having a first bias current path and a first intermediate node; providing a second gain stage having a second bias current path and a second intermediate node; providing a third gain stage having a third bias current path and a third intermediate node; providing a fourth gain stage having a fourth bias current path and fourth intermediate node; isolating the first intermediate node from the second intermediate node with a first resistor; and isolating the third intermediate node from the fourth intermediate node with a second resistor.

While various polarities and types of transistors have been illustrated and described, the polarities can be reversed and the types of transistor can be changed to suit a particular application. In addition, various control and supply voltages have been described, which can also be changed to suit a particular application. Any component values described herein, such as resistor values, can also be changed to suit a particular application.

While this invention has been described with reference to illustrative embodiments, this description is not intended to be construed in a limiting sense. Various modifications and combinations of the illustrative embodiments, as well as other embodiments of the invention, will be apparent to persons skilled in the art upon reference to the description. It is therefore intended that the appended claims encompass any such modifications or embodiments.

## Claims

1. A programmable gain amplifier comprising:
a differential input comprising a first input node and a second input node;
a differential output comprising a first output node and a second output node;
a first control node and a second control node;
a first cascode leg having an input coupled to the first input node, an output coupled to the first output node, a control node coupled to the first control node, and an intermediate node;
a second cascode leg having an input coupled to the first input node, an output coupled to the second output node, a control node coupled to the second control node, and an intermediate node;
a third cascode leg having an input coupled to the second input node, an output coupled to the first output node, a control node coupled to the second control node, and an intermediate node;
a fourth cascode leg having an input coupled to the second input node, an output coupled to the second output node, a control node coupled to the first control node, and an intermediate node;
a current source coupled to the first, second, third, and fourth cascode legs;
a first resistor coupled between the intermediate node of the first cascode leg and the intermediate node of the second cascode leg; and
a second resistor coupled between the intermediate node of the third cascode leg and the intermediate node of the fourth cascode leg.

2. The programmable gain amplifier of claim 1, wherein a voltage at the first control node is configured to be greater than a voltage at the second control node in a first mode of operation, wherein the voltage at the first control node is configured to be less than a voltage at the second control node in a second mode of operation, and wherein the voltage at the first control node is configured to be equal to the voltage at the second control node in a third mode of operation.

3. The programmable gain amplifier of claim 2, wherein a phase deviation of an output signal at the differential output is less than 0.5° in the first and second modes of operation.

4. The programmable gain amplifier of claim 1, further comprising a first load coupled to the first output node and a second load coupled to the second output node, wherein the first and second loads comprise complex loads.

5. The programmable gain amplifier of any of the preceding claims, wherein a value of the first and second resistors is between about 5 and 25 ohms or is about 10 ohms.

6. The programmable gain amplifier of any of the preceding claims, wherein the first, second, third, and fourth cascode legs each comprise a first transistor coupled to a second transistor in a cascode configuration.

7. The programmable gain amplifier of any of the preceding claims, wherein the programmable gain amplifier comprises a bipolar programmable gain amplifier or a Metal Oxide Semiconductor (MOS) gain amplifier.

8. An amplification method for use in a programmable gain amplifier comprises:
providing a first gain stage having a first bias current path and a first intermediate node;
providing a second gain stage having a second bias current path and a second intermediate node;
providing a third gain stage having a third bias current path and a third intermediate node;
providing a fourth gain stage having a fourth bias current path and a fourth intermediate node;
isolating the first intermediate node from the second intermediate node with a first resistor; and
isolating the third intermediate node from the fourth intermediate node with a second resistor.

9. The method of claim 8, further comprising configuring the first, second, third, and fourth gain stages to provide a non-inverting mode of operation, an inverting mode of operation, and an attenuating mode of operation.

10. The method of claim 9, wherein a phase deviation of an output signal at a differential output of the programmable gain amplifier is less than 0.5° in the non-inverting mode of operation and in the inverting mode of operation.

11. The method of any of claims 8 to 10, wherein a value of the first and second resistors is between about 5 and 25 ohms or is about 10 ohms.

12. An integrated circuit comprising:
a plurality of signal paths each comprising a transceiver, a phase adjustment circuit, and an amplitude adjustment circuit; and
a summing circuit coupled to the plurality of signal paths,
wherein the transceiver comprises at least one programmable gain amplifier comprising a plurality of gain stages each having a separate bias current path, wherein first and second gain stages of the plurality of gain stages are coupled together with a first resistor, and wherein third and fourth gain stages of the plurality of gain stages are coupled together with a second resistor.

13. The integrated circuit of claim 12, wherein the programmable gain amplifier is configured to provide a non-inverting mode of operation, an inverting mode of operation, and an attenuating mode of operation.

14. The programmable gain amplifier of claim 13, wherein a phase deviation of an output signal at a differential output of the programmable gain amplifier is less than 0.5° in the non-inverting mode of operation and in the inverting mode of operation.

15. The programmable gain amplifier of any of claims 12 to 14, wherein a value of the first and second resistors is between about 5 and 25 ohms or is about 10 ohms.
